# FASCICULE DE BREVET EUROPEEN

(11) **EP 0 851 577 B1**
(45) Date de publication et mention de la délivrance du brevet: **24.07.2002**
(21) Numéro de dépôt: 97403132.0
(22) Date de dépôt: 23.12.1997
(51) Int. Cl.: H03G 3/00, H03G 3/30

(54) **Dispositif d'alimentation d'un amplificateur de puissance pour terminal de radiocommunications mobiles**
Spannungszuführung zur Lestungsverstärkung in einem mobilen Telefonendgerät
Power supplying device for power amplification in a mobile telephone terminal

(30) Priorité: 30.12.1996 FR 9616193
(43) Date de publication de la demande: 01.07.1998
(73) Titulaire: ALCATEL, 75008 Paris (FR)
(72) Inventeur: Sarrazin, Emile, Saint Brice Sur Foret (FR); Attimont, Luc, 78560 Le Port Marly (FR)
(74) Mandataire: El Manouni, Josiane

(56) Documents cités:
- EP-A- 0 110 355
- EP-A- 0 626 765
- US-A- 5 126 688

## Description

La présente invention concerne d'une manière générale les terminaux de radiocommunications mobiles , et plus particulièrement l'alimentation des amplificateurs de puissance prévus dans ces terminaux, en vue de réaliser un contrôle de la puissance émise.

Dans un système de radiocommunications mobiles cellulaire, il est connu de contrôler cette puissance émise en fonction d'une consigne de puissance issue du système lui-même, fonction notamment de l'éloignement des mobiles par rapport aux éléments d'infrastructure, appelés aussi stations de base, avec lesquels ils sont en relation, afin de réduire le niveau global d'interférence dans ce système.

Dans un système de radiocommunications mobiles numérique utilisant la technique de l'accès multiple à répartition temporelle, il est par ailleurs connu de contrôler cette puissance émise en fonction de la forme d'onde des signaux à émettre. Plus précisément, les informations à transmettre étant mises sous forme de paquets, ou "bursts", destinés à être émis dans des intervalles de temps prédéterminés d'une structure de trame, cette forme d'onde présente un palier, correspondant à la partie utile de ce paquet, précédé d'une rampe montante et suivi d'une rampe descendante, ces deux rampes correspondant à des temps de garde entourant cette partie utile.

Pour alimenter un amplificateur de puissance de manière à réaliser un tel contrôle de la puissance émise, il est connu de prévoir un tripôle actif de puissance pour la commande de cet amplificateur de puissance, ce tripôle actif recevant, outre une tension de commande fonction de la puissance à émettre, une tension d'alimentation dite tension d'alimentation de ce tripôle actif, et fournissant à cet amplificateur de puissance un courant d'alimentation donné sous une tension d'alimentation donnée dite tension d'alimentation de cet amplificateur de puissance. Ladite tension d'alimentation du tripôle actif est en outre en général fixe et donc en pratique déterminée en fonction de la puissance maximale à émettre.

Un tel montage a essentiellement pour inconvénient de présenter un mauvais rendement pour de faibles puissances d'émission car le produit dudit courant d'alimentation par la chute de tension aux bornes de ce tripôle actif peut alors atteindre des valeurs relativement élevées.

Pour éviter cet inconvénient, il est connu, par le document EP 0 626 765, et pour un système de radiocommunications mobiles analogiques, de fournir ledit courant d'alimentation et ladite tension d'alimentation de l'amplificateur au moyen d'un convertisseur de tension comportant lui-même un tripôle actif de commande qui est commandé en fonction de la puissance à émettre, mais qui ne fournit pas lui-même la totalité desdits courant et tension d'alimentation de l'amplificateur de puissance, mais seulement la partie de ces courant et tension d'alimentation qui est variable en fonction de la puissance d'émission demandée.

Une telle solution ne convient pas pour les systèmes de radiocommunications mobiles numériques tels que rappelés plus haut, ou plus généralement pour tout système dans lequel la puissance d'émission est susceptible de varier relativement rapidement, c'est-à-dire trop rapidement par rapport aux délais de réaction nécessaires à un tel convertisseur de tension, du fait de la présence à l'intérieur de celui-ci de composants tels qu'inductances et condensateurs ayant des constantes de temps relativement élevées. Pour donner un ordre de grandeur, dans le système de radiocommunications mobiles connu sous le nom de GSM (pour "Global System for Mobile Communication"), les signaux émis sont susceptibles de varier de 70 dB au cours desdites rampes montantes et descendantes, pendant des temps de l'ordre de 30 microsecondes.

La présente invention a notamment pour but de permettre une amélioration de rendement pour de faibles puissances d'émission, tout en étant applicable à de tels systèmes dans lesquels la puissance à émettre est susceptible de varier relativement rapidement.

La présente invention a ainsi pour objet un dispositif d'alimentation d'un amplificateur de puissance pour terminal de radiocommunications mobiles, apte à fournir une puissance d'émission susceptible de présenter des variations relativement rapides et des variations relativement lentes, ce dispositif étant essentiellement caractérisé en ce qu'il comporte:
- un tripôle actif de puissance pour la commande dudit amplificateur de puissance, recevant une tension de commande fonction desdites variations relativement rapides, et une tension dite d'alimentation de ce tripôle actif, et fournissant audit amplificateur de puissance un courant d'alimentation donné sous une tension donnée dite tension d'alimentation de cet amplificateur de puissance,
- des moyens de génération de tension d'alimentation dudit tripôle actif, aptes à fournir audit tripôle actif une tension d'alimentation variable de manière à ce que, pour une valeur donnée de ladite puissance d'émission susceptible de présenter des variations relativement lentes, la chute de tension aux bornes dudit tripôle actif soit minimale.

D'autres objets et caractéristiques de la présente invention apparaîtront à la lecture de la description suivante d'exemples de réalisation, faite en relation avec les dessins ci-annexés dans lesquels:
- la figure 1 est un schéma destiné à illustrer un premier exemple de réalisation d'un dispositif d'alimentation suivant l'invention,
- la figure 2 est un schéma destiné à illustrer un deuxième exemple de réalisation d'un dispositif d'alimentation suivant l'invention,
- la figure 3 est un schéma destiné à illustrer un troisième exemple de réalisation d'un dispositif d'alimentation suivant l'invention.

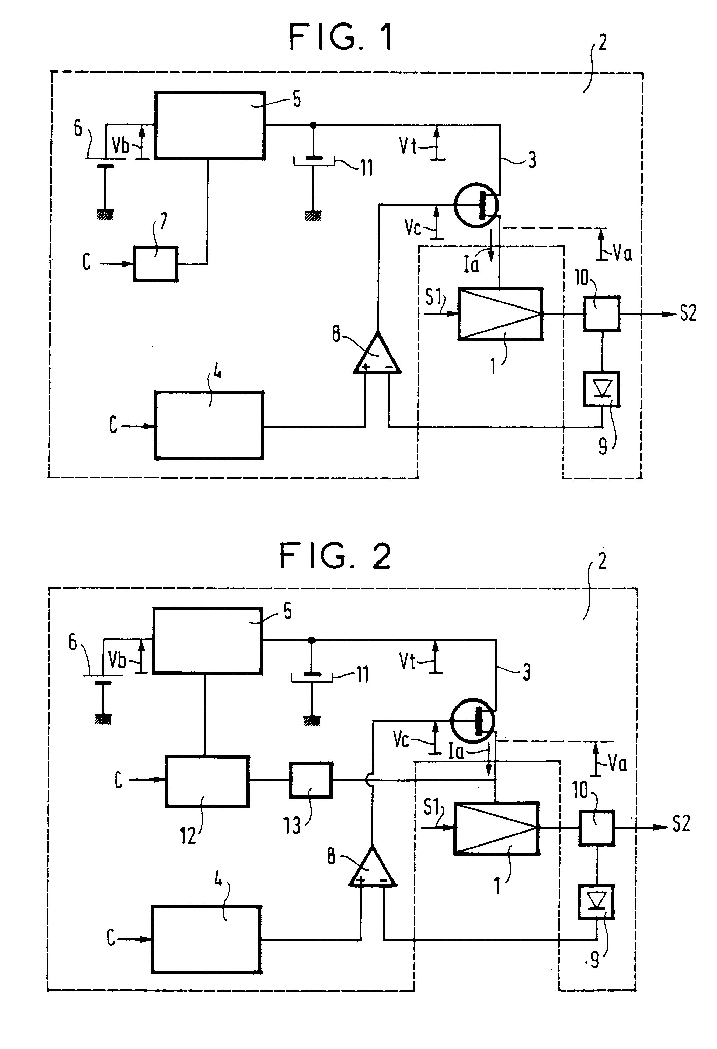

Sur la figure 1 est illustré un amplificateur de puissance 1 pour terminal de radiocommunications mobiles. Cet amplificateur de puissance reçoit un signal à amplifier S1 représentant les informations à transmettre, et est alimenté par un dispositif d'alimentation 2 permettant de réaliser un contrôle de la puissance d'émission du signal amplifié S2 correspondant.

Le système de radiocommunications mobiles considéré est en l'occurrence un système numérique utilisant la technique de l'accès multiple à répartition temporelle. Lesdites informations à transmettre sont donc en l'occurrence mises sous forme de paquets, ou "bursts", destinés à être émis dans des intervalles de temps prédéterminés d'une structure de trame, et la puissance d'émission du signal porteur de ces informations est donc en l'occurrence, comme rappelé plus haut, susceptible de varier relativement rapidement.

Le système de radiocommunications mobiles considéré est en outre en l'occurrence un système cellulaire, auquel cas la puissance d'émission est en outre susceptible de variations plus lentes correspondant, comme rappelé plus haut, à un contrôle de cette puissance par le système de radiocommunications mobiles lui-même, afin de réduire le niveau global d'interférence dans ce système.

Le dispositif d'alimentation 2 de l'amplificateur de puissance 1 comporte un tripôle actif de puissance 3 pour la commande dudit amplificateur de puissance, ce tripôle actif recevant une tension de commande Vc fonction de la puissance à émettre et une tension Vt dite tension d'alimentation de ce tripôle actif, et fournissant audit amplificateur de puissance un courant d'alimentation donné Ia sous une tension donnée Va dite tension d'alimentation de cet amplificateur de puissance.

Le tripôle actif 3 peut être constitué par tout composant d'électronique de puissance tel que par exemple un transistor bipolaire ou un transistor à effet de champ.

La tension de commande Vc de ce tripôle actif 3 est en l'occurrence issue d'un générateur de tensions de commande 4 apte à générer diverses formes d'onde de tensions de commande correspondant aux divers types de paquets susceptibles d'être transmis dans le système considéré (tels que par exemple, dans le système GSM, des paquets dits d'accès, ou "RACCH" (pour: "Random Access Control Channel") ou des paquets dits de trafic, ou "TCH" (pour: Traffic Channel")), et, pour chacun de ces types de paquets, à diverses consignes de puissance d'émission reçues du système, ce générateur 4 recevant un signal de commande extérieur C permettant de sélectionner l'une ou l'autre de ces diverses tensions de commande possibles.

Le dispositif d'alimentation 2 comporte en outre des moyens 5 dits de génération de tension d'alimentation dudit tripôle actif, aptes à fournir une tension d'alimentation Vt variable de manière à ce que, pour une consigne de puissance d'émission donnée reçue du système, la chute de tension Vt-Va aux bornes dudit tripôle actif soit minimale.

Ainsi, bien que le tripôle actif 3 fournisse lui-même la totalité du courant et de la tension d'alimentation de l'amplificateur de puissance 1, le rendement est amélioré, par rapport à l'art antérieur rappelé plus haut, pour de faibles puissances d'émission, tout en ayant ainsi un dispositif d'alimentation qui autorise des variations relativement rapides de la puissance d'émission.

Pour éviter un fonctionnement de ce tripôle actif 3 en régime de saturation, qui entraînerait lui-même une déformation des signaux émis, il est en outre préférable que la tension d'alimentation Vt fournie par les moyens 5 soit telle que la chute de tension Vt-Va aux bornes du tripôle actif reste supérieure à un seuil minimum.

Dans l'exemple illustré sur la figure 1, les moyens 5 comportent un convertisseur de tension commandé pour fournir, à partir d'une tension fixe Vb fournie par une batterie 6, une tension Vt variable de manière à ce que, pour une puissance d'émission donnée, la chute de tension Vt-Va aux bornes du tripôle actif 3 soit minimale.

De tels convertisseurs de tension commandables sont connus et ne seront donc pas redécrits ici. Le signal de commande d'un tel convertisseur peut par exemple être issu d'une table de correspondance 7 dont le contenu peut être déterminé par exemple expérimentalement. Dans l'exemple illustré sur la figure 1, une telle table de correspondance est adressée par un signal de commande extérieur, qui peut par exemple être le même que le signal C reçu par le générateur 4.

Les deux causes possibles de variation de la puissance d'émission (variations relativement lentes et variations relativement rapides) étant ainsi découplées l'une de l'autre, et seule la commande fonction de l'éloignement de la station mobile (correspondant auxdites variations relativement lentes) étant appliquée à ce convertisseur de tension, le problème de l'insuffisance de rapidité d'un tel convertisseur pour le cas d'un système opérant en "bursts" (correspondant auxdites variations relativement rapides) ne se pose pas.

Pour éliminer les diverses causes possibles qui font qu'en pratique ( notamment à cause de la température, du vieillissement des composants...etc.) la puissance émise peut ne pas correspondre rigoureusement à celle attendue correspondant à une tension de commande donnée, il est en outre prévu un asservissement de cette puissance émise à celle correspondant à cette tension de commande, cet asservissement étant en l'occurrence réalisé au moyen d'un amplificateur différentiel 8 recevant d'une part la tension de commande issue du générateur 4, et d'autre part une tension représentative de la puissance réellement émise, obtenue au moyen d'un détecteur 9 opérant sur une fraction de puissance émise prélevée au moyen d'un coupleur 10.

Pour limiter les appels de courant sur les moyens 5 de génération de tension d'alimentation du tripôle actif lors des variations rapides des formes d'onde correspondant aux signaux à transmettre, il est en outre avantageusement prévu, en parallèle sur ces moyens de génération 5, un condensateur 11 dit aussi condensateur-réservoir.

Le dispositif d'alimentation illustré sur la figure 2 ne diffère de celui illustré sur la figure 1 que par le fait que la table de correspondance, notée ici 12, est adressée par la tension d'alimentation réelle Va de l'amplificateur de puissance, le contenu de cette table étant déterminé, par exemple expérimentalement, de manière à ajuster la tension Vt fournie par les moyens 5, pour que l'écart Vt-Va entre ces deux tensions reste inférieur à une valeur seuil prédéterminée. La valeur de la tension d'alimentation Va de l'amplificateur de puissance est en l'occurrence donnée par un détecteur de tension crête 13 connecté à l'entrée d'alimentation de l'amplificateur de puissance 1.

En outre, une telle commande étant plutôt destinée à fonctionner en régime établi, une commande au moyen de ladite consigne extérieure C peut, comme illustré sur la figure 2, subsister pour permettre à un tel système de converger plus rapidement vers la valeur voulue au cours d'une phase d'initialisation précédant un tel fonctionnement en régime établi. Le contenu de ladite table de correspondance est alors déterminé, par exemple expérimentalement, pour permettre à cette table d'être ainsi adressée à la fois par cette consigne extérieure et par la valeur de tension d'alimentation Va ainsi détectée.

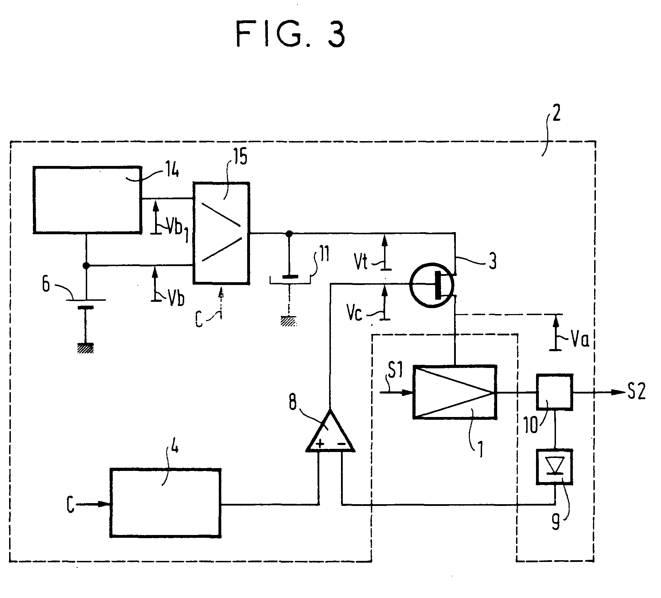

Le dispositif d'alimentation illustré sur la figure 3 ne diffère de celui illustré sur la figure 1 que par la réalisation des moyens 5 qui comportent ici un convertisseur de tension 14 fournissant, à partir de la tension fixe Vb fournie par la batterie 6, une tension Vb1 différente de Vb, et un commutateur 15 recevant d'une part la tension Vb fournie par la batterie 6, d'autre part la tension Vb1 issue de ce convertisseur de tension 14, et sélectionnant l'une ou l'autre de ces tensions en fonction de la puissance d'émission demandée, représentée par le signal C.

Bien que ce dispositif soit moins performant que le précédent (puisque la tension Vt ne peut prendre ici que deux valeurs possibles) il a cependant l'avantage d'une plus grande simplicité de réalisation, notamment due au fait que les modifications à apporter à un dispositif d'alimentation classique pour le rendre conforme à la présente invention sont moindres que dans le cas de la figure 1 puisqu'il suffit ici de prévoir un commutateur tel que le commutateur 15, un convertisseur non commandable tel que le convertisseur 14 étant en effet généralement déjà prévu dans un terminal de radiocommunications mobiles pour fournir, à partir d'une tension telle que Vb utilisée pour l'alimentation de circuits autres que des circuits de puissance, une tension telle que Vb1 supérieure à Vb, utilisée pour l'alimentation des circuits de puissance.

## Revendications

1. Dispositif d'alimentation d'un amplificateur de puissance (1) pour terminal de radiocommunications mobiles, apte à fournir une puissance d'émission susceptible de présenter des variations relativement rapides et des variations relativement lentes, ce dispositif (2) étant **caractérisé en ce qu'**il comporte:
- un tripôle actif de puissance (3) pour la commande dudit amplificateur de puissance, recevant une tension de commande (Vc) fonction desdites variations relativement rapides et une tension (Vt) dite d'alimentation de ce tripôle actif, et fournissant audit amplificateur de puissance un courant d'alimentation donné (Ia) sous une tension donnée (Va) dite tension d'alimentation de cet amplificateur de puissance,
- des moyens (5) de génération de tension d'alimentation dudit tripôle actif, aptes à fournir audit tripôle actif une tension d'alimentation (Vt) variable de manière à ce que, pour une valeur donnée de ladite puissance d'émission susceptible de présenter des variations relativement lentes, la chute de tension aux bornes dudit tripôle actif soit minimale.

2. Dispositif selon la revendication 1, **caractérisé en ce que** lesdits moyens (5) de génération de tension d'alimentation dudit tripôle actif sont commandés par un signal issu d'une table de correspondance (7) adressée par une consigne extérieure de puissance d'émission (C).

3. Dispositif selon la revendication 1, **caractérisé en ce que** lesdits moyens (5) de génération de tension d'alimentation dudit tripôle actif sont commandés par un signal issu d'une table de correspondance adressée par un signal représentatif de la tension d'alimentation de l'amplificateur de puissance.

4. Dispositif selon la revendication 1, **caractérisé en ce que** lesdits moyens (5) de génération de tension d'alimentation dudit tripôle actif ssont commandés par un signal issu d'une table de correspondance (12) adressée par une consigne extérieure de puissance d'émission (C) et par un signal représentatif de la tension d'alimentation de l'amplificateur de puissance.

5. Dispositif selon l'une des revendications 1 à 4, **caractérisé en ce que** lesdits moyens (5) de génération de tension d'alimentation dudit tripôle actif comportent un convertisseur de tension fournissant, à partir d'une tension fixe (Vb), une tension d'alimentation variable (Vt).

6. Dispositif selon l'une des revendications 1 à 4, **caractérisé en ce que** lesdits moyens (5) de génération de tension d'alimentation dudit tripôle actif comportent un convertisseur de tension (14) fournissant, à partir d'une tension fixe (Vb), dite première tension fixe, une tension fixe de valeur différente (Vb1), dite deuxième tension fixe, et un commutateur (15) commandé pour sélectionner l'une ou l'autre de ces première et deuxième tensions fixes, de façon à ce que, pour une puissance d'émission donnée, la chute de tension aux bornes dudit tripôle actif soit minimale.

7. Dispositif selon l'une des revendications 1 à 6, **caractérisé en ce qu'**il comporte en outre un condensateur (11) dit condensateur-réservoir, en parallèle sur la sortie desdits moyens de génération de tension d'alimentation dudit tripôle actif.

8. Terminal de radiocommunications mobiles, comportant un dispositif selon l'une des revendications 1 à 7.

## Claims

1. A power supply circuit for a power amplifier (1) of a mobile radio communication terminal, the power amplifier being suitable for delivering transmitter power that can present variations that are relatively fast and variations that are relatively slow, the power supply circuit (2) being characterized it that it comprises:
· an active three-pole power device (3) for controlling said power amplifier, the device receiving both a control voltage (Vc) that is a function of said relatively fast variation and an active three-pole device power supply voltage (Vt), and delivering to said power amplifier a given power supply current (la) at a given voltage (Va) referred to as the power supply voltage for said power amplifier; and
· means (5) for generating the power supply voltage for said active three-pole device, and suitable for delivering to said active three-pole device a power supply voltage (Vt) that is variable in such a manner that for a given value of said transmission power that is subject to relatively slow variations, the voltage drop across the terminals of said active three-pole device is minimal.

2. A circuit according to claim 1, **characterized in that** said means (5) for generating the power supply voltage for said active three-pole device are controlled by a signal from a correspondence table (7) addressed by an external reference for transmission power (C).

3. A circuit according to claim 1, **characterized in that** said means (5) for generating the power supply voltage for said active three-pole device are controlled by a signal from a correspondence table addressed by a signal representative of the power supply voltage of the power amplifier.

4. A circuit according to claim 1, **characterized in that** said means (5) for generating the power supply voltage for said active three-pole device are controlled by a signal from a correspondence table (12) addressed by an external reference for transmission power (C) and by a signal representative of the power supply voltage of the power amplifier.

5. A circuit according to any one of claims 1 to 4, **characterized in that** said means (5) for generating the power supply voltage for said active three-pole device comprise a voltage converter delivering a variable power supply voltage (Vt) derived from a fixed voltage (Vb).

6. A circuit according to any one of claims 1 to 4, **characterized in that** said means (5) for generating the power supply voltage for said active three-pole device comprise a voltage converter (14) delivering, from a first fixed voltage (Vb), a second fixed voltage of different value (Vb1), and a switch (15) controlled to select one or other of said first and second fixed voltages, in such a manner that for given transmission power, the voltage drop across the terminals of said active three-pole device is minimal.

7. A circuit according to any one of claims 1 to 6, **characterized in that** it further includes a tank-capacitor (11) in parallel with the output of said means for generating the power supply voltage of said active three-pole device.

8. A mobile radio communication terminal including a circuit according to any one of claims 1 to 7.

## Patentansprüche

1. Vorrichtung zur Spannungsversorgung eines Leistungsverstärkers (1) für ein Mobilfunkendgerät, das in der Lage ist, eine Sendeleistung zu liefern, die relativ schnelle und relativ langsame Leistungsänderungen aufweisen kann, wobei die Vorrichtung (2) **dadurch gekennzeichnet ist, dass** sie umfasst:
einen aktiven Leistungs-Tripol (3) für die Steuerung des Leistungsverstärkers, der eine Steuerspannung (Vc), die Funktion der relativ schnellen Änderungen ist, und eine als Versorgungsspannung bezeichnete Spannung (Vt) dieses aktiven Tripols empfängt und an den Leistungsverstärker einen gegebenen Versorgungsstrom (Ia) unter einer als Versorgungsspannung des Leistungsverstärkers bezeichneten gegebenen Spannung (Va) liefert,
Mittel (5) zum Erzeugen der Versorgungsspannung des aktiven Tripols, die in der Lage sind, an den aktiven Tripol eine Versorgungsspannung (Vt) zu liefern, die derart veränderlich ist, dass für einen gegebenen Wert der Sendeleistung, die relativ langsame Änderungen aufweisen kann, der Spannungsabfall an den Klemmen des aktiven Tripols minimal ist.

2. Vorrichtung nach Anspruch 1, **dadurch gekennzeichnet, dass** die Mittel (5) zum Erzeugen der Versorgungsspannung des aktiven Tripols durch ein Signal gesteuert sind, das aus einer Korrespondenztabelle (7) hervorgeht, die durch einen externen Sendeleistungssollwert (C) adressiert ist.

3. Vorrichtung nach Anspruch 1, **dadurch gekennzeichnet, dass** die Mittel (5) zum Erzeugen der Versorgungsspannung des aktiven Tripols durch ein Signal gesteuert sind, das aus einer Korrespondenztabelle (7) hervorgeht, die durch ein für die Versorgungsspannung des Leistungsverstärkers repräsentatives Signal adressiert ist.

4. Vorrichtung nach Anspruch 1, **dadurch gekennzeichnet, dass** die Mittel (5) zum Erzeugen der Versorgungsspannung des aktiven Tripols durch ein Signal gesteuert sind, das aus einer Korrespondenztabelle (12) hervorgeht, die durch einen externen Sendeleistungssollwert (C) und durch ein für die Versorgungsspannung des Leistungsverstärkers repräsentatives Signal adressiert ist.

5. Vorrichtung nach Anspruch 1, **dadurch gekennzeichnet, dass** die Mittel (5) zum Erzeugen der Versorgungsspannung des aktiven Tripols einen Spannungswandler umfassen, der ausgehend von einer festen Spannung (Vb) eine variable Versorgungsspannung (Vt) liefert.

6. Vorrichtung nach einem der Ansprüche 1 bis 4, **dadurch gekennzeichnet, dass** die Mittel (5) zum Erzeugen der Versorgungsspannung des aktiven Tripols einen Spannungswandler (14), der ausgehend von einer festen Spannung (Vb), als erste feste Spannung bezeichnet, eine feste Spannung von anderem Wert (Vb1), als zweite feste Spannung bezeichnet, liefert, und einen Schalter (15) umfassen, der gesteuert ist, um die eine oder andere dieser ersten und zweiten festen Spannungen so auszuwählen, dass für eine gegebene Sendeleistung der Spannungsabfall an den Klemmen des aktiven Tripols minimal ist.

7. Vorrichtung nach einem der Ansprüche 1 bis 6, **dadurch gekennzeichnet, dass** sie ferner einen als Speicherkondensator bezeichneten Kondensator (11) parallel am Ausgang der Mittel zum Erzeugen der Versorgungsspannung des aktiven Tripols aufweist.

8. Mobilfunkendgerät, mit einer Vorrichtung nach einem der Ansprüche 1 bis 7.
